# EUROPEAN PATENT SPECIFICATION

(11) **EP 0 264 222 B1**
(45) Date of publication and mention of the grant of the patent: **02.03.1994**
(21) Application number: 87308868.6
(22) Date of filing: 07.10.1987
(51) Int. Cl.: H01L 21/268, H01L 21/263, H01L 29/14

(54) **Selective intermixing of layered structures composed of thin solid films**
Selektive Verbindung von mehrschichtigen Strukturen aus festen Dünnschichten
Interalliage sélectif de structures feuilletées composées de films solides fins

(30) Priority: 09.10.1986 US 916818
(43) Date of publication of application: 20.04.1988
(73) Proprietor: AMOCO CORPORATION, Chicago Illinois 60601 (US)
(72) Inventor: Ralston, John Duncan, Ithaca New York 14850 (US); Moretti, Anthony Luke, Naperville Illinois 60565 (US); Jain, Ravinder Kumar, Warrenville Illinois 60555 (US)
(74) Representative: Lewin, John Harvey

(56) References cited:
- WO-A-82/03946
- US-A- 4 654 090
- US-A- 4 689 646
- MATERIALS RESEARCH SYMPOSIA PROCEEDING, vol. 51, 1986, pages 185-189 ; Pittsburgh, US N.V. JOSHI et al. : "Formation of A1xGa1-xAs alloy on the semi-insulating GaAs substrate by laser beam interaction".
- APPLIED PHYSICS LETTERS, vol. 50, no. 25, June 22, 1987, pages 1817-1819 ; Am. Inst. of Physics, New York, US, J. RALSTON et al. : "Intermixing of A1xGa1-xAs/GaAs superlattices by pulsed laser irradiation".

## Description

### TECHNICAL FIELD

This invention relates to synthetic layered semiconductor structures and their modification, both laterally and vertically, to provide novel electronic, optoelectronic, and optical properties. This is accomplished by selective intermixing of such layered structures through selective irradiation with laser beam or electron beam energy sources to effect reaction between adjacent layers to a depth dependent on the energy density.

### BACKGROUND ART

A particular class of synthetic layered structures of considerable importance is the semiconductor superlattice in which two semiconductor materials with different electronic properties are interleaved in thin layers either (1) by depositing sheets of two semiconducting materials in an alternating manner, or (2) by introducing impurities into layers of a single semiconducting material. The former is designated as a compositional, or heterostructure, superlattice, and the latter is designated as a doping superlattice. Thus, a compositional superlattice comprises a periodic array consisting of alternating layers of two different semiconductors. Each layer has a thickness in the range from a single atomic layer up to several hundred atomic layers. In a compositional superlattice, the two semiconductors are so chosen that their band gaps, i.e., the difference in energy between the valence and conduction bands, differ significantly.

In the literature, a structure composed of two thin films of different semiconductors is called a single heterostructure. A structure composed of a semiconductor film of lower band gap sandwiched between two semiconductor layers of larger band gap is referred to as a double heterostructure. When the middle layer is sufficiently thin, the structure is called a single quantum well (SQW). A periodic structure composed of alternating layers of two different semiconductors is sometimes also referred to as a multiple-quantum-well (MQW) or a superlattice depending on the thickness of the semiconductor layer with the larger band gap. For the purposes of this invention, the distinction between a superlattice and a MQW is not essential, and thus the term "superlattice" will be used henceforth for the sake of simplicity. As used herein, it is intended that the term "selective intermixing" includes also the case where all regions of a synthetic layered structure are intermixed as well as the case where only a limited portion thereof is intermixed.

Specifically, each layer of the semiconductor having the smaller band gap produces what is referred to as a potential well in either the conduction band or the valence band, or in both. In terms of optical and electronic properties, important distinctions can be made between three different types of semiconductor superlattices, commonly referred as as types of I, Iʹ, and II, depending on the relative alignment of the conduction and valence bands in the two semiconductors. However, for the purposes of this invention, such distinctions are not essential. Inside each potential well, only certain energy states or levels are available to the confined carriers (electrons in the conduction-band or holes in the valence-band). The values of the energy levels available to the electrons can be selectively controlled by appropriate choice of semiconductor materials and the width of their layers. In this fashion, the electronic and/or optical properties of SQW's, or of compositional or doping superlattices, can be tailored.

It is generally well known in the art that in a semiconductor multilayer structure, the semiconductor with the smaller band gap can be a material such as gallium arsenide (GaAs) and the one with the larger band gap can be a material such as aluminum gallium arsenide (AlₓGa₁₋ₓAs), wherein x represents a variable aluminum mole fraction. Compositional superlattices and SQW's consisting of gallium arsenide and aluminum gallium arsenide are generally grown by metalorganic chemical vapor deposition (MO-CVD), molecular beam epitaxy (MBE), liquid phase epitaxy (LPE), or other suitable deposition techniques. The preferable techniques are generally considered to be the MO-CVD and MBE processes.

Since it is necessary to laterally modify the doping, mobility, band gap and refractive index of the epitaxially grown compound semiconductor layers (such as doping or compositional superlattices) for monolithic integration of all relevant optical components, there has arisen the need to perform selective intermixing of different semiconductor layers, typically of thickness ranging from about 5 Å to about 5 microns (where 10Å = 1nm and 1 micron = 1µm), comprising device structures such as GaAs/AlₓGa₁₋ₓAs superlattices and related heterostructures used for optoelectronics. Heretofore, in the prior art, such selective intermixing has been achieved by either localized diffusion or implantation of both donor or acceptor impurities.

In particular, a method is disclosed in U.S. patent no. 4,378,255 by which a multilayer, group III-V semiconductor structure can be disordered and shifted up in energy gap into single crystalline form by the expedient of a zinc diffusion. This patent teaches that all, or selected portions, of a multilayer of either gallium arsenide/aluminum arsenide or gallium arsenide/aluminum gallium arsenide can be converted into a single crystal aluminum gallium arsenide having a higher energy gap than that of the original structure by the process of zinc diffusion at low temperature. However, this prior art technique suffers from the disadvantage that substantial intermixing of the superlattice layers requires diffusion times on the order of hours. Furthermore, this prior art technique is unable to obtain such intermixing without the introduction of substantial impurity atom concentration into the superlattice materials.

Another recently reported technique relates to the formation of AlₓGa₁₋ₓAs alloy on a semi-insulating GaAs substrate by irradiating a two-layer structure of AlAs and GaAs with a high power continuous wave (cw) argon laser. This technique was reported by N. V. Joshi and J. Lehman in "Formation of AlₓGa₁₋ₓAs Alloy on the Semi-insulating GaAs Substrate by Laser Beam Interaction", Materials Research Society Symposia Proceedings, Vol 51, pp. 185-189 (1986). However, the reported quality of the alloyed material obtained by this method, based on a stationary or quasi-stationary continuous wave beam, appears to be inferior and often leads to destruction of the material. No mention is made in this report of the use of pulsed or of rapidly scanned laser or electron beams with dwell times of a fraction of a second to grow alloys or to intermix relatively complex structures to obtain intermixed materials of high quality or final composite structures of high complexity.

Another recent development is reported in U.S. patent no. 4,654,090 wherein selected areas of a semiconductor structure are converted into a disordered alloy by thermal treatment in a protected environment. The structure is heated to a temperature near the melting point, where rapid thermal disordering will occur (about 750-850°C), and then scanned with a laser beam, typically from a semiconductor laser device. The protected environment may be a closed vessel, for avoiding loss of vapor due to the high temperature, or may be a covering, or shroud, to accomplish the same purpose.

US-A-4689646 (equivalent to JP-A-60258971) discloses the use of a pulsed laser beam with a pulse length of several seconds to achieve intermixing of alternate semiconductor layers.

Reference is also made as prior art to the handbook "Laser Annealing of semiconductors", edited by Poate and Mayer, Academic Press (1982).

It would therefore be desirable to provide an improved process for more rapid and selective intermixing of multilayered semiconductor materials whereby superior electronic and optical properties are obtained without the necessity of introducing impurity atoms into the material or heating the bulk material to very high temperatures. Moreover, in contrast to the work of Joshi and Lehman, it would be desirable to provide a new method that would be applicable to the intermixing of complex multilayered structures such as laser heterostructures and superlattices. Such an improvement would enhance the entire field of integrated optics/optical signal processing. Such improvements are achieved in the present invention by utilizing pulsed directed energy sources such as those derived from suitably chosen laser beams or electron beams for intermixing of multilayered structures.

### DISCLOSURE OF THE INVENTION

Accordingly, it is a general object of the present invention to provide an improved process for selective intermixing of layered structures, such that the method is relatively simple and yet overcomes the disadvantages of the prior art.

The present invention provides a process for the selective intermixing of selected lateral and/or vertical regions of quantum well and barrier layers within a compositional superlattice of a semiconductor structure to secure distinctively altered optical and electronic properties of said intermixed regions as compared to unmixed regions of said layers of said compositional superlattice, with an abrupt transition from said intermixed regions to said unmixed regions, each layer having a thickness within the range of from 0.5 to 50 nm (5 to 500 Å), with said structure having at least one exposed surface layer, said process comprising the steps of:
irradiating said semiconductor structure over a selected area of an exposed surface layer of said semiconductor structure by pulsing said radiation with a predetermined pulse duration in the range of from 10 to 30 ns, and
controlling the energy density of said radiation to effect intermixing of said selected lateral and/or vertical regions of said quantum well and barrier layers within said compositional superlattice, the energy density being in the range of from 50 to 400 mJ/cm², whereby a predetermined number of periods of said superlattice structure is intermixed to a depth dependent on the energy density and the transition from the intermixed phase to the unperturbed superlattice structure is very abrupt.

One embodiment of the present invention is to provide a process for selective intermixing of multilayered semiconductor structures such as varied heterostructures and superlattices by irradiating with a single pulse from a suitable laser or electron beam.

Another embodiment of the present invention provides a process for selective intermixing of multilayered semiconductor structures by irradiating with a series of pulses from a suitable laser or electron beam in order to increase the degree of intermixing.

A further embodiment of the present invention provides a method for selective intermixing of GaAs/AlₓGa₁₋ₓAs multilayers by irradiating with either a single pulse or a series of pulses from a frequency-doubled Nd:YAG laser or excimer laser.

The present invention will become more fully apparent from the following detailed description, when read in conjunction with accompanying drawings with like reference numerals indicating corresponding parts throughout, wherein:
Figures 1 and 2 show enlarged, side elevational views of two superlattice samples for use in the present invention;
Figure 3 is a block diagram of an apparatus for selective intermixing of a superlattice, constructed in accordance with the principles of the present invention, and utilizing an excimer laser as the energy source;
Figure 4 is a block diagram of an apparatus for selective intermixing of a superlattice, constructed in accordance with the principles of the present invention, and utilizing a frequency-doubled Nd:YAG laser as the energy source;
Figures 5 and 6 are, respectively, Raman scattering profiles of an as-grown region of the sample in Figure 1 and a region of the sample which has been irradiated with a single pulse from a KrF excimer laser;
Figures 7 and 8 are, respectively, sputter-Auger composition-depth profiles of an as-grown region of the sample in Figure 1 and a region of the sample which has been irradiated with a single pulse from a KrF excimer laser; and
Figures 9 and 10 are Raman scattering profiles of an as-grown region of the sample in Figure 2 and a region of the sample which has been irradiated with five pulses from a frequency-doubled Nd:YAG laser.

In the process of this invention multilayered semiconductor structures are selectively intermixed by an annealing treatment. Such structures may be superlattices, or compositional superlattices. Such structures may consist of as few as two layers, as, for example, a quantum-well layer and a barrier layer. Similarly, such structures may consist of either single or double heterostructures. More generally, such layered structures comprise many layers, of alternating quantum-well and barrier types, each layer of the structure having a thickness ranging from about 5 to about 500 Å and thus constituting up to several hundred atomic layers. Doping superlattices may also be employed and, where specific effects may be desired, other types of layers may be interspersed as well. The total thickness of the layered semiconductor structure may be as great as from about 5 to about 10 microns, thus ranging from about 50,000 to about 100,000 Å.

In the process of this invention, the annealing treatment may be conducted at any desired temperature, selected primarily for convenience in operation. Generally preferred temperatures include ambient temperature, while permissible temperatures range down to 0°C and lower or up to several hundred degrees C although a generally acceptable range extends from about 0°C to about 50°C. Pressure is not a critical variable and operation at ambient pressure is generally preferred.

In the process of this invention, a surface layer of the multilayered semiconductor structure is irradiated with an energy source which is adapted to provide an energy density which is sufficient to effect the desired intermixing between alternating layers. It has been found that this can be readily accomplished, with surprising ease and effectiveness, by employing a pulsed laser beam or electron beam as the energy source. Combination of such beams may also be employed. One preferred energy source comprises pulsed excimer laser beams, particularly the KrF laser beam, having a wavelength of 248 nanometers.

The energy density should be selected to avoid significant damage to the multilayered structure. The desired effect is an intermixing which provides selected lateral and/or vertical regions which exhibit optical, opto-electronic, and/or electronic properties which are different from those of the original semiconductor structure. In some instances this will comprise the conversion of a compositional superlattice to an alloy structure. One proposed mechanism for this result, by which we do not wish to be bound and mention only for discussion purposes, would involve a selective melting of portions of the structure, followed by recrystallization, thus implying that very high temperatures are achieved. If this be so, then it is apparent that the existence of such high temperatures must be limited to periods of short duration to avoid possible physical damage to the structure.

In the practice of this invention, it has been observed that in some instances a single pulse of a pulsed laser beam is sufficient to accomplish the desired intermixing. Often it has been observed that only a few pulses are required.

The degree of intermixing decreases gradually from the surface of the multilayered sample to a depth depending upon the energy density, after which the original compositional modulation remains intact. However the intermixing is believed to be a cumulative process.

In optimizing the process of this invention with respect to the degree of intermixing, a heated sample mount may be employed to minimize thermal gradients within the semiconductor structure and substantially reduce residual lattice damage and strain.

From the foregoing description, it can be seen that the present invention provides a novel and improved process for selective intermixing of superlattice layers by irradiating with a single pulse from a laser. Further, the irradiation can be with multiple laser pulses or other combinations of pulsed laser and electron beam sources, so as to increase the degree of intermixing. This process should also be applicable to a wide range of other layered structures including, but not limited to, metallic superlattices and semiconductor superlattices in different crystal systems.

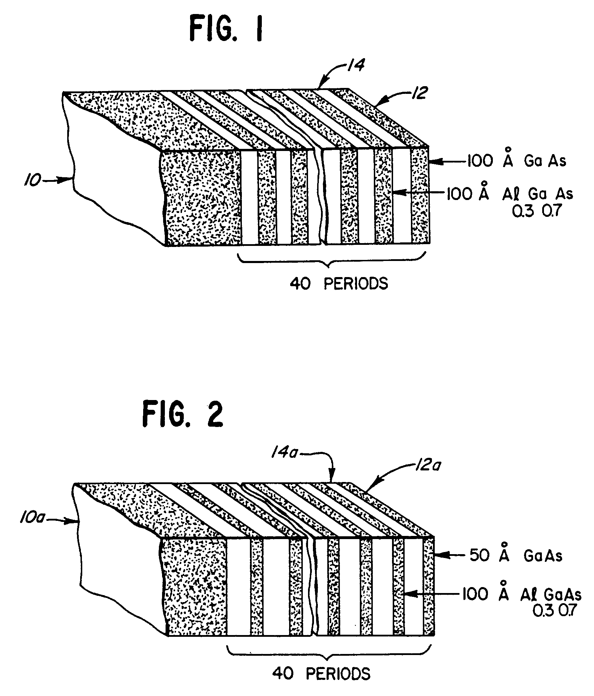

In the drawings, Figure 1 represents a multilayer structure 10 composed of separate layers of thin solid films, referred to as a superlattice, comprised of 40 periods. Each period consists of a quantum-well layer 12 and a barrier layer 14. In the superlattice 10, each quantum-well layer 12 has a thickness of approximately 100 Å and each barrier layer 14 has a thickness of approximately 100 Å. The quantum-well layers 12 have a smaller band gap and may be formed of a semiconductor material such as gallium arsenide (GaAs). The barrier layers 14 have a larger band gap and may be formed of a semiconductor material such as aluminum gallium arsenide (AlₓGa₁₋ₓAs) with aluminum mole fraction x=0.3. The value of x=0.3 has been chosen as an illustrative example; other values can also be easily used. Figure 2 shows another superlattice structure 10a, having 40 periods, with each period consisting of a GaAs quantum-well layer 12a and a Al_{0.3}Ga_{0.7} As barrier layer 14a. Each of the quantum-well layers 12a has a thickness of approximately 50 Å, and each of the barrier layers 14a has a thickness of approximately 100 Å.

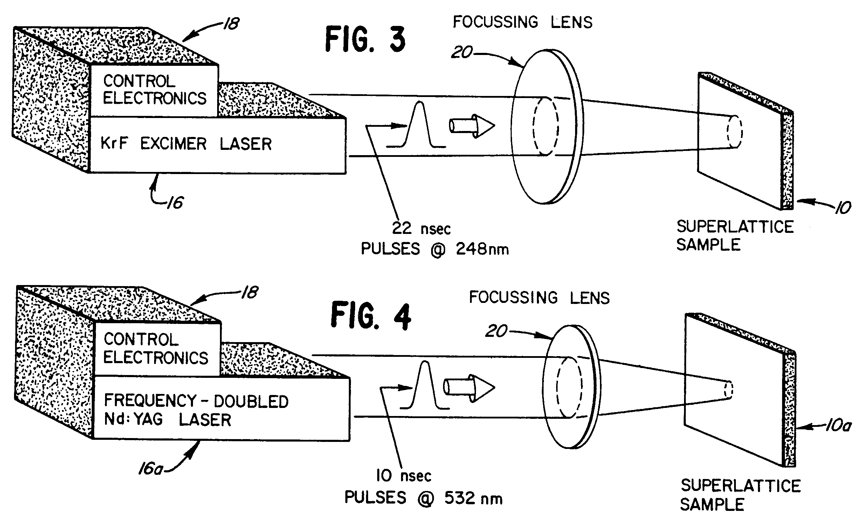

Figures 3 and 4 illustrate apparatus utilized for selective intermixing of a superlattice in accordance with the principles of the present invention. Each apparatus includes an energy source or laser device 16 or 16a which generates a pulsed output with a varying amount of energy per pulse under the control of a power controller 18. The laser device 16 is a commercially available krypton fluoride (KrF) excimer laser operating at a wavelength of approximately 248 nanometers (nm) with a pulse duration of about 22 nsec. The excimer laser is provided with a single-shot or multiple-pulse firing capability. The laser 16a is a commercially available frequency-doubled Q-switched/Nd:YAG (an acronym for neodymium; yttrium, aluminum and garnet) laser having also a single-shot or multiple-pulse firing capability. The Nd:YAG laser operates at a wavelength of approximately 532 nm with a pulse duration of about 10 nsec. The output of the laser device 16 or 16a is directed onto the superlattice sample 10 or 10a via a focussing lens 20. The energy density incident on superlattice sample 10 or 10a is varied by adjusting the laser pulse energy or the focussed spot size at the sample surface.

Other available energy sources include a pulsed electron beam. The laser wavelength and incident power are chosen with respect to the absorption length and thermal diffusion properties of the layered structure so that a sufficient power density is deposited in those regions of the sample which are to be intermixed. The pulse duration of the pulsed energy source is chosen with respect to the stability of the various elements or compounds in the layered structure so as to avoid chemical decomposition of, or mechanical damage to, the structure during the intermixing process. Such times have been determined to be 10 to 30 ns for the structures described in the following examples.

The following examples serve to illustrate, without limitation, the process of this invention and the novel, improved semiconductor products made thereby.

### Example I

A semiconductor superlattice structure sample was selected, consisting or 40 periods of gallium arsenide quantum-well layers, having a thickness of 100 Å, and aluminum gallium arsenide (Al_{0.3}Ga_{0.7}As) barrier layers, also having a thickness of 100 Å, as shown in Figure 1. The sample was irradiated in selected areas, employing the apparatus of Figure 3 with a KrF laser at 248 nm wavelength, with a series of 22 ns pulses where the energy density was varied from about 100 to about 900 mJ/cm².

For energy densities exceeding about 400 mJ/cm² (in a single 22 ns pulse), visible damage (cratering, probably due to decomposition of the GaAs and AlₓGa₁₋ₓAs layers) was induced in the sample. For an incident energy density of 220 mJ/cm², no visible crystal damage resulted. However, the reflective properties of the irradiated region were altered, giving rise to a surface which, although not cratered or roughened, appears slightly different even to the naked eye.

### Example II

A semiconductor superlattice structure sample was selected, consisting of 40 periods of gallium arsenide quantum-well layers, having a thickness of 50 Å, and aluminum gallium arsenide (Al_{0.3}Ga_{0.7}As) barrier layers, having a thickness of 100 Å, as shown in Figure 2. The sample was irradiated in selected areas, employing the apparatus of Figure 4, with a frequency-doubled Nd:YAG laser at 532 nm wavelength, with a series of 10 ns pulses where the energy density was varied from about 50 to about 400 mJ/cm².

When the laser intermixing was performed with a single pulse of 10 ns duration and an estimated energy density of 400 mJ/cm² incident on the sample surface, visible damage ("cratering") was induced. However, when an energy density of approximately 50 mJ/cm² was used there was no visible crystal damage due to the irradiation by a single pulse.

### Example III

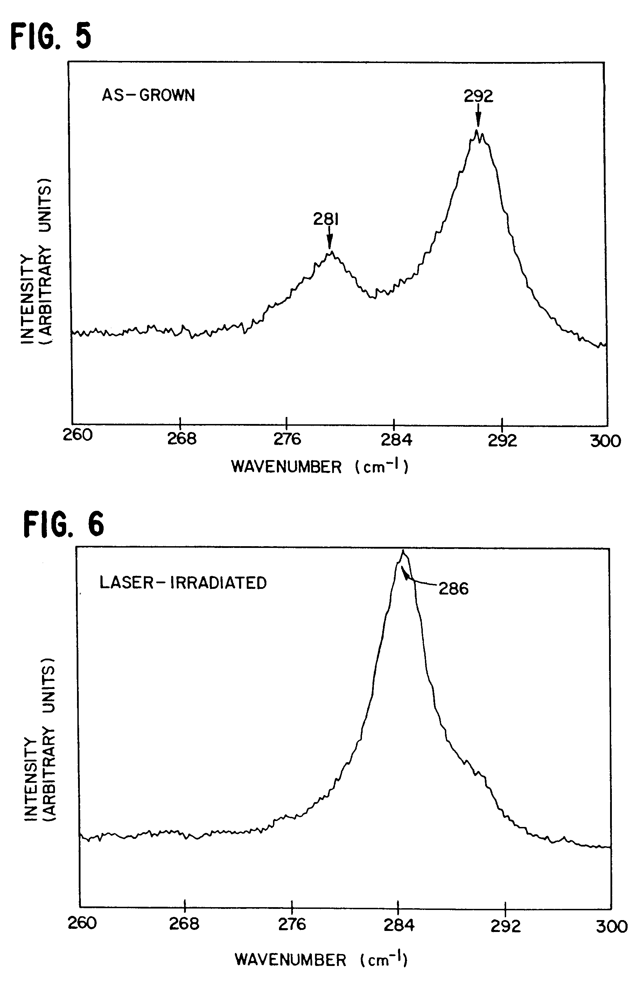

Raman scattering spectra were measured on as-grown and excimer laser-irradiated regions of the sample 10 of Figure 1 (see Example I) for evaluation of the degree of intermixing produced by the present invention. Figure 5 shows the Raman spectrum of an as-grown region of the sample. As can be seen, a longitudinal optical (LO) phonon peak appears at a frequency of 292 cm⁻¹ due to the pure GaAs layers and a GaAs-like LO phonon peak appears at a frequency of 281 cm⁻¹ due to the Al_{0.3}Ga_{0.7}As layers. Figure 6 presents the Raman spectrum from a region of the same sample which has been irradiated by a single excimer laser pulse at an energy density of approximately 200 mJ/cm². As seen, only a single GaAs-like phonon peak is observed, at a frequency of 286 cm⁻¹, corresponding to an intermixed AlₓGa₁₋ₓAs alloy of the expected median composition where x=0.15. These data indicate that extensive intermixing of the original superlattice layers in the sample has occurred.

### Example IV

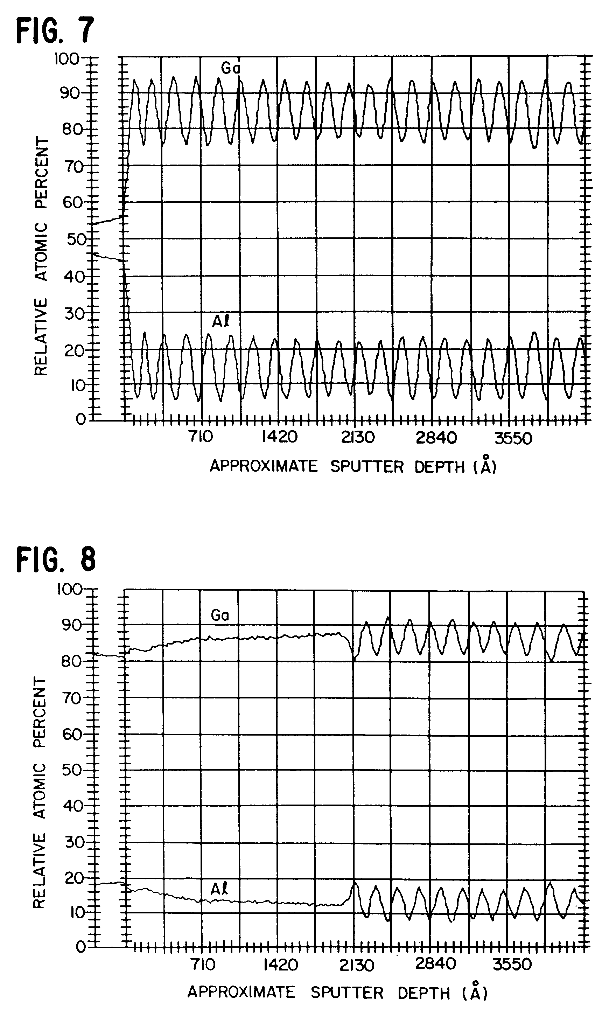

The extent of the interdiffusion of the GaAs layers and the Al_{0.3}Ga_{0.7}As layers was determined by the technique of sputter-Auger profiling, which utilizes a combination of physical sputtering and Auger electron spectroscopy to generate a composition-depth profile of the layered structure. Figure 7 shows both Ga and Al depth profiles through the first 21 periods (to a depth of about 4200 Å) of the as-grown region of the sample 10 in Figure 1. The effect of laser irradiation (see Example I) is dramatic as shown in Figure 8. Complete intermixing of the first 11 periods (about 2200 Å) has occurred. In addition, the transition from the intermixed phase to the unperturbed superlattice structure is observed to be very abrupt. The Al mole fraction of the intermixed alloy is very close to x=0.15, as expected. The above data indicate that the excimer laser irradiation is capable of generating complete intermixing of GaAs/AlₓGa₁₋ₓAs superlattice layers, with abrupt vertical transition between the intermixed and unmixed regions.

### Example V

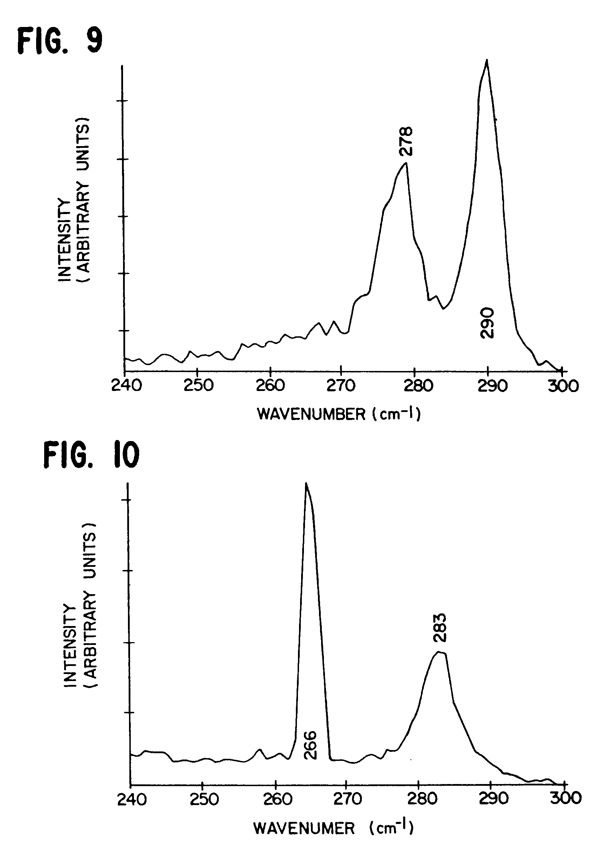

Raman scattering spectra were also measured on as-grown and Nd:YAG laser-irradiated regions (see Example II) of the superlattice sample 10a of Figure 2. Figure 9 shows the Raman spectrum of an as-grown region of the sample. Again, LO phonon peaks appear at frequencies of 278 cm⁻¹ and 290 cm⁻¹, corresponding to the Al_{0.3}Ga_{0.7}As and GaAs layers, respectively. Figure 10 shows the Raman spectrum from a region of the same sample which has been irradiated with five pulses from the Nd:YAG laser 16a of Figure 3 at an energy density of 120 mJ/cm² for each pulse. The single relatively narrow LO phonon peak at a frequency of 283 cm⁻¹ corresponds to a thoroughly intermixed AlₓGa₁₋ₓAs alloy of median composition x=0.2, as expected from complete intermixing of the original layered structure. In addition, a prominent symmetry-forbidden transverse optical (TO) phonon peak is observed at a frequency of 266 cm⁻¹, indicative of microscopic lattice damage or strain. This may be due to thermal gradients within the volume of the sample irradiated by the Nd:YAG laser, since the output beam from this device has been observed to provide a non-uniform intensity profile. It is believed that microscopic lattice damage and strain can be minimized by ensuring laser beam uniformity and, in addition, by using a heated sample mount to reduce thermal gradients in the sample during irradiation.

### Example VI

A semiconductor superlattice structure sample was selected, consisting of 30 periods of gallium arsenide layers, having a thickness of 100 Å, and aluminum gallium arsenide (Al_{0.3}Ga_{0.7}As) layers, having a thickness of 100 Å, uniformly doped with silicon to a concentration level of about 6x10¹⁷cm⁻³. The laser apparatus of Figure 4 (Example II) was employed for irradiation with a series of 10 ns pulses where the energy density was varied from about 50 to about 400 mJ/cm².

At energy densities greater than about 70 mJ/cm² visible damage at the surface was observed.

### BEST MODE FOR CARRYING OUT THE INVENTION

The best mode for operating the process of this invention substantially follows the procedure set forth in Example I. The selected layered semiconductor structure is intermixed by irradiation with a pulsed excimer laser beam, generally providing an energy density ranging from about 100 to about 400 mJ/cm² at a dwell time of from about 10 to about 30 ns. Both quantum-well and barrier layers may vary in thickness preferably from about 30 to about 150 Å. There are no specific requirements for temperature and pressure parameters so that ambient conditions are generally to be preferred.

### INDUSTRIAL APPLICABILITY

The process of this invention is ideally suited to provide a novel and direct tailoring of properties of semiconductor structures to provide novel materials for performances not hitherto attainable. A simple, direct selective intermixing for layered structures affords both lateral and vertical modification of the doping, mobility, band gap, and refractive index in electronic, optoelectronic, and optical components, including field-effect transistors, lasers, detectors, waveguides and bistable switching elements.

By elimination of doping, it becomes possible to provide such novel and improved components in a higher degree of purity and reproducibility.

## Claims

1. A process for the selective intermixing of selected lateral and/or vertical regions of quantum well and barrier layers within a compositional superlattice of a semiconductor structure to secure distinctively altered optical and electronic properties of said intermixed regions as compared to unmixed regions of said layers of said compositional superlattice, with an abrupt transition from said intermixed regions to said unmixed regions, each layer having a thickness within the range of from 0.5 to 50 nm (5 to 500 Å), with said structure having at least one exposed surface layer, said process comprising the steps of:
irradiating said semiconductor structure over a selected area of an exposed surface layer of said semiconductor structured by pulsing said radiation with a predetermined pulse duration in the range of from 10 to 30 ns and
controlling the energy density of said radiation to effect intermixing of said selected lateral and/or vertical regions of said quantum well and barrier layers within said compositional superlattice, the energy density being in the range of from 50 to 400 mJ/cm², whereby a predetermined number of periods of said superlattice structure is intermixed to a depth dependent on the energy density and the transition from the intermixed phase to the unperturbed superlattice structure is very abrupt.

2. The process of claim 1 wherein the quantum-well layers consist of gallium arsenide.

3. The process of claim 2 wherein the barrier layers consist of aluminum gallium arsenide, having the formula AlₓGa₁₋ₓAs.

4. The process of claim 3 wherein the fraction x is selected to be within the range from about 0.1 to about 0.5.

5. The process of claim 3 wherein the quantum-well layers consist of gallium arsenide and the barrier layers consist of Al_{0.3}Ga_{0.7}As.

6. The process of claim 5 wherein the selected regions of the intermixed semiconductor product structure consist of Al_{0.15}Ga_{0.85}As.

7. The process of claim 2 wherein the quantum-well layers have a thickness within the range from about 3 to 15 nm (30 to 150 Å).

8. The process of claim 7 wherein the quantum-well layers have a thickness within the range from about 5 to 10 nm (50 to 100 Å).

9. The process of claim 3 wherein the barrier layers have a thickness within the range from about 3 to 15 nm (30 to 150 Å).

10. The process of claim 9 wherein the thickness of the barrier layers is about 10 nm (100 Å).

11. The process of claim 3 wherein the multilayered semiconductor structure is at a temperature within the range from about 0° to about 50°C.

12. The process of claim 3 wherein the multi-layered semiconductor structure is at a substantially ambient temperature and pressure.

13. The process of claim 1 wherein the energy source is selected from the class consisting of pulsed laser beams, pulsed electron beams, and combinations thereof.

14. The process of claim 1 wherein the energy source is an excimer laser beam.

15. The process of claim 14 wherein the excimer laser beam is a KrF laser beam having a wavelength of 248 nm.

16. The process of claim 1 wherein the energy source comprises a single pulse from a pulsed laser beam.

17. The process of claim 1 wherein the energy source comprises multiple pulses from a pulsed laser beam.

18. The process of claim 5 wherein the energy source comprises a single pulse from a pulsed KrF laser beam.

19. The process of claim 1 wherein the multi-layered semiconductor structure includes impurity atoms in one species of alternating layers to afford a doping superlattice.

## Patentansprüche

1. Verfahren zum selektiven Vermischen von ausgewählten Lateral- und oder Vertikalbereichen von Potentialtopf- und Barriere-Schichten innerhalb einer zusammengesetzten Supergitter-Halbleiterstruktur zur Erzielung ausgeprägt geänderter optischer und elektronischer Eigenschaften der vermischten Bereiche gegenüber ungemischten Bereichen dieser Schichten des zusammengesetzten Supergitters, wobei ein abrupter Übergang von den vermischten zu den ungemischten Bereichen vorliegt, wobei jede Schicht eine Dicke im Bereich von 0.5 bis 50 nm (5 bis 500 Å) aufweist, und wobei die Struktur mindestens eine freiliegende Oberlächenschicht aufweist, wobei das Verfahren folgende Schritte umfaßt:
Bestrahlen der Halbleiterstruktur über einen ausgewählten Bereich einer freiliegenden Oberflächenschicht der Halbleiterstruktur mit einer gepulsten Strahlung vorgegebener Pulsdauer im Bereich von 10 bis 30 ns, und
Steuern der Energiedichte der Strahlung zur Erzielung einer Mischung der ausgewählten Lateral- und/oder Vertikalbereiche der Potentialtopf- und Barriere-Schichten innerhalb des zusammengesetzten Supergitters, wobei die Energiedichte im Bereich von 50 bis 400 mJ/cm² liegt, wodurch eine vorgegebene Anzahl von Perioden der Supergitterstruktur bis zu einer von der Energiedichte abhängigen Tiefe vermischt und der Übergang von der vermischten Phase zu der ungestörten Supergitterstruktur sehr abrupt wird.

2. Verfahren nach Anspruch 1, wobei die Potentialtopf-Schichten aus Galliumarsenid bestehen.

3. Verfahren nach Anspruch 2, wobei die Barriereschichten aus Aluminiumgalliumarsenid der Formel AlₓGa₁₋ₓAs bestehen.

4. Verfahren nach Anspruch 3, wobei der Anteil x innerhalb des Bereichs von etwa 0,1 bis etwa 0,5 gewählt wird.

5. Verfahren nach Anspruch 3, wobei die Potentialtopf-Schichten aus Galliumarsenid und die Barriereschichten aus Al_{0,3}Ga_{0,7}As bestehen.

6. Verfahren nach Anspruch 5, wobei die ausgewählten Bereiche der erhaltenen vermischten Halbleiterstruktur aus Al_{0,15}Ga_{0,85}As bestehen.

7. Verfahren nach Anspruch 2, wobei die Potentialtopf-Schichten eine Dicke im Bereich von etwa 3 bis 15 nm (30 bis 150 Å) aufweisen.

8. Verfahren nach Anspruch 7, wobei die Potentialtopf-Schichten eine Dicke im Bereich von etwa 5 bis 10 nm (50 bis 100 Å) aufweisen.

9. Verfahren nach Anspruch 3, wobei die Barriereschichten eine Dicke im Bereich von etwa 3 bis 15 nm (30 bis 150 Å) aufweisen.

10. Verfahren nach Anspruch 9, wobei die Dicke der Barriereschichten etwa 10 nm (100 Å) beträgt.

11. Verfahren nach Anspruch 3, wobei die mehrschichtige Halbleiterstruktur bei einer Temperatur im Bereich von etwa 0°C bis etwa 50°C erzeugt wird.

12. Verfahren nach Anspruch 3, wobei die mehrschichtige Halbleiterstruktur bei im wesentlichen Umgebungstemperatur und -druck erzeugt wird.

13. Verfahren nach Anspruch 1, wobei die Energiequelle aus gepulsten Laserstrahlen, gepulsten Elektronenstrahlen und Kombinationen davon ausgewählt wird.

14. Verfahren nach Anspruch 1, wobei die Energiequelle ein Excimer-Laserstrahl ist.

15. Verfahren nach Anspruch 14, wobei der Excimer-Laserstrahl ein KrF-Laserstrahl einer Wellenlänge von 248 nm ist.

16. Verfahren nach Anspruch 1, wobei die Energiequelle einen einzelnen Impuls eines gepulsten Laserstrahls umfaßt.

17. Verfahren nach Anspruch 1, wobei die Energiequelle mehrere Impulse eines gepulsten Laserstrahls umfaßt.

18. Verfahren nach Anspruch 5, wobei die Energiequelle einen einzelnen Impuls eines gepulsten KrF-Laserstrahls umfaßt.

19. Verfahren nach Anspruch 1, wobei die mehrschichtige Halbleiterstruktur Störstoffatome in einer Art von abwechselnden Schichten zur Erzielung eines dotierten Supergitters enthält.

## Revendications

1. Procédé d'interalliage sélectif de régions latérales et/ou verticales de feuillets de puits quantique et de barrière quantique au sein d'un super-réseau de composition d'une structure de semi-conducteur, pour garantir des propriétés optiques et électroniques distinctement modifiées desdites régions interalliées, par rapport à des régions non alliées desdits feuillets dudit super-réseau de composition, avec une transition abrupte entre lesdites régions interalliées et lesdites régions non alliées, chaque feuillet ayant une épaisseur dans la gamme de 0,5 à 50 nm (5 à 500 Å), ladite structure possédant au moins un feuillet superficiel exposé, ledit procédé comprenant les étapes consistant à :
irradier ladite structure du semi-conducteur, sur une surface choisie d'un feuillet superficiel exposé de ladite structure du semi-conducteur, par des impulsions dudit rayonnement, avec une durée d'impulsion prédéterminée dans la gamme de 10 à 30 ns, et
régler la densité d'énergie dudit rayonnement pour effectuer l'interalliage desdites régions latérales et/ou verticales choisies desdits feuillets de puits quantique et de barrière quantique au sein dudit super-réseau de la composition, la densité d'énergie étant dans la gamme de 50 à 400 mJ/cm²,
grâce à quoi un nombre prédéterminé de périodes de ladite structure en super-réseau est interalliée à une profondeur dépendant de la densité d'énergie, et la transition entre la phase interalliée et la structure en super-réseau non perturbée est très abrupte.

2. Procédé selon la revendication 1, dans lequel les feuillets de puits quantique sont constitués d'arséniure de gallium.

3. Procédé selon la revendication 2, dans lequel les feuillets de barrière quantique sont constitués d'arséniure d'aluminium et de gallium de formule AlₓGa₁₋ₓAs.

4. Procédé selon la revendication 3, dans lequel la fraction x est choisie comme étant dans la gamme d'environ 0,1 à environ 0,5.

5. Procédé selon la revendication 3, dans lequel les feuillets de puits quantiques sont constitués d'arséniure de gallium et les feuillets de barrière quantique sont constitués de Al_{0,3}Ga_{0,7}As.

6. Procédé selon la revendication 5, dans lequel les régions choisies de la structure du produit semi-conducteur interallié sont constituées de Al_{0,15}Ga_{0,85}As.

7. Procédé selon la revendication 2, dans lequel les feuillets de puits quantique ont une épaisseur dans la gamme d'environ 3 à 15 nm (30 à 150 Å).

8. Procédé selon la revendication 7, dans lequel les feuillets de puits quantique ont une épaisseur dans la gamme d'environ 5 à 10 nm (50 à 100 Å).

9. Procédé selon la revendication 3, dans lequel les feuillets de barrière ont une épaisseur dans la gamme d'environ 3 à 15 nm (30 à 150 Å).

10. Procédé selon la revendication 9, dans lequel l'épaisseur des feuillets de barrière est d'environ 10 nm (100 Å).

11. Procédé selon la revendication 3, dans lequel la structure du semi-conducteur à plusieurs feuillets est à une température dans la gamme d'environ 0° à environ 50°C.

12. Procédé selon la revendication 3, dans lequel la structure du semi-conducteur à plusieurs feuillets est à une température et à une pression essentiellement ambiantes.

13. Procédé selon la revendication 1, dans lequel la source d'énergie est choisie dans la classe constituée par les faisceaux laser impulsionnels, des faisceaux électroniques impulsionnels, et des combinaisons de ceux-ci.

14. Procédé selon la revendication 1, dans lequel la source d'énergie est un faisceau laser excimère.

15. Procdé selon la revendication 14, dans lequel le faisceau laser excimère est un faisceau laser au KrF dont la longueur d'onde est de 248 nm.

16. Procédé selon la revendication 1, dans lequel la source d'énergie comprend une seule impulsion d'un faisceau laser impulsionnel.

17. Procédé selon la revendication 1, dans lequel la source d'énergie comprend plusieurs impulsions d'un faisceau laser impulsionnel.

18. Procédé selon la revendication 5, dans lequel la source d'énergie comprend une seule impulsion d'un faisceau laser au KrF.

19. Procédé selon la revendication 1, dans lequel la structure du semi-conducteur à plusieurs feuillets comprend des atomes d'impuretés dans une des espèces de feuillets alternés, pour produire un super-réseau de dopage.
